# EUROPEAN PATENT APPLICATION

(11) **EP 1 818 842 A1**
(43) Date of publication of application: **15.08.2007**
(21) Application number: 07003007.7
(22) Date of filing: 13.02.2007
(51) Int. Cl.: G06F 17/50

(54) **Apparatus and methods for parallelizing integrated circuit computer-aided design software**

(30) Priority: 13.02.2006 US 772747 P; 29.03.2006 US 392215
(71) Applicant: Altera Corporation, San Jose, CA 95134 (US)
(72) Inventor: Padalia, Ketan, Thornhill, ON, L4J6R6 (CA); Ludwin, Adrian, Toronto, ON M6G2S9 (CA); Betz, Vaughn, Toronto, ON M6S4A8 (CA); Fung, Ryan, Mississauga, ON, L4W3L6 (CA)
(74) Representative: Appelt, Christian W.

(57) **Abstract**

A system for providing parallelization in computer aided design (CAD) software includes a computer. The computer is configured to identify a set of tasks having local independence, and assign each task in the set of tasks to be performed in parallel. The computer is further configured to perform each task in the set of tasks.

## Description

### Cross-Reference to Related Applications

This application claims priority to, and incorporates by reference, Provisional U.S. Patent Application Serial No. 60/772,747, Attorney Docket No. ALTR:OSSPZ1, titled "Apparatus and Methods for Parallelizing Software," filed on February 13,2006.

### Technical Field

Generally, the disclosed concepts relate to apparatus and methods for parallelizing software and algorithms. More specifically, the concepts relate to apparatus and methods for parallelizing computer-aided design (CAD) software for integrated circuits (ICs), such as programmable logic devices (PLDs).

### Background

Traditionally, processors (such as the Pentium series from Intel, Athlon series from AMD, etc) have become faster by supporting ever-increasing clock speeds. As processors got faster in this way, the time used up to run a particular piece of software on these processors automatically sped up proportionally (because the time to execute a single instruction of code is roughly proportional to the speed of the processor clock).

New generations of processors being released today, however, are not using clocks that are significantly faster than they were two years ago (about 3GHz). Instead, these processor chips now include more than one processor inside them (e.g., Pentium D processors are "dual core," meaning they have two mini-processors in one chip). This property enables the computer to simultaneously run several "threads" of execution.

Any software that is serial (meaning that it has one task to perform at a time) does not speed up with the availability of additional processors in these chips. In order to leverage the additional processing power, serial software needs to be parallelized, meaning it has to have multiple tasks that are ready to be executed in order to keep all the processors busy. Unfortunately, this parallelization can almost never be done automatically, as it entails modifying the software code. The modifications themselves are also fairly tricky, as many of the assumptions that underlie serial software break down in parallel software. A need therefore exists for parallelizing software, such as CAD software

### Summary

The disclosed novel concepts relate to apparatus and methods for parallelizing software, such as CAD software and algorithms. One aspect of the inventive concepts relates to methods of parallelizing CAD software, such as PLD CAD software. In one embodiment, a method according to the invention includes of identifying a set of tasks having independence, and assigning each task in the set of tasks to be performed in parallel. The method further includes performing each task in the set of tasks.

Another aspect of the invention relates to a system for parallelizing software, where the system includes a computer configured to perform the parallelization method described above. Yet another aspect of the inventive concepts pertains to computer program products that include computer applications adapted for processing by a computer to parallelize software. The computer applications cause the computer to perform the software parallelization method described above.

### Brief Description of the Drawings

The appended drawings illustrate only exemplary embodiments of the invention and therefore should not be considered or construed as limiting its scope. Persons of ordinary skill in the art who have the benefit of the description of the invention appreciate that the disclosed inventive concepts lend themselves to other equally effective embodiments. In the drawings, the same numeral designators used in more than one drawing denote the same, similar, or equivalent functionality, components, or blocks.

FIG. 1 shows a technique for parallelization used in exemplary embodiments by using multiple threads.

FIG. 2 illustrates another technique for parallelization used in exemplary embodiments by using multiple processors.

FIG. 3 depicts a general block diagram of a PLD that may be designed or used by using illustrative embodiments of the invention.

FIG. 4 shows a floor-plan of a PLD that one may design or implement by using the inventive concepts.

FIG. 5 illustrates various software modules that PLD CAD software according to illustrative embodiments of the invention uses.

FIG. 6 shows a simplified block diagram of a parallelization technique.

FIG. 7 depicts illustrates an example of an initial configuration of a device floorplan.

FIG. 8 shows the device floorplan of FIG. 7 after the acceptance of the moving of a resource.

FIG. 9 illustrates a proposal for moves of resources in a device floorplan.

FIG. 10 shows a parallelization technique according to an exemplary embodiment.

FIG. 11 depicts an example of a serial analysis algorithm.

FIG. 12 shows an example of the parallelization of an analysis algorithm.

FIG. 13 illustrates a block diagram of a system for processing information using the disclosed concepts.

### Detailed Description

The inventive concepts contemplate apparatus and associated methods for parallelizing software, such as CAD algorithms or software, or CAD software for FPGAs. The disclosed concepts seek to run software or algorithms in parallel, for example, by using threading or multiple processors, so as to improve the speed of execution.

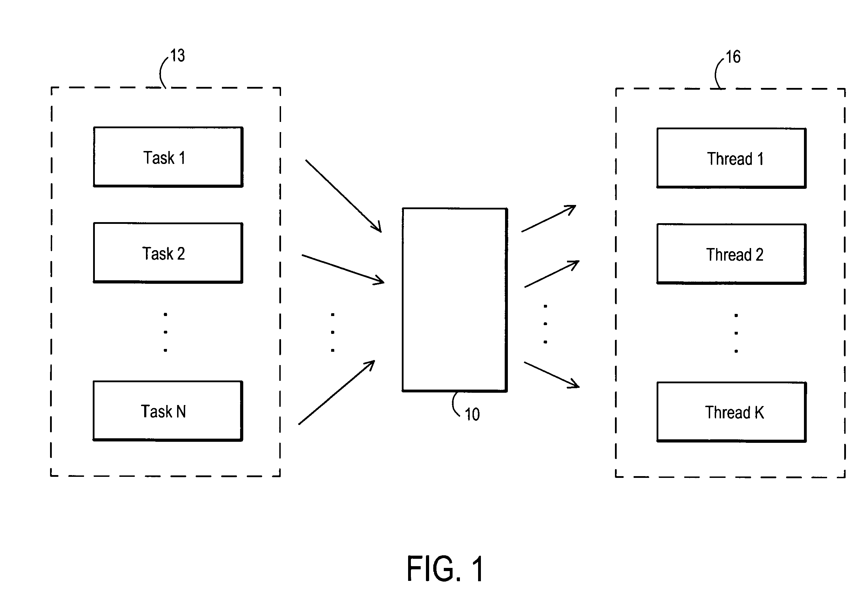

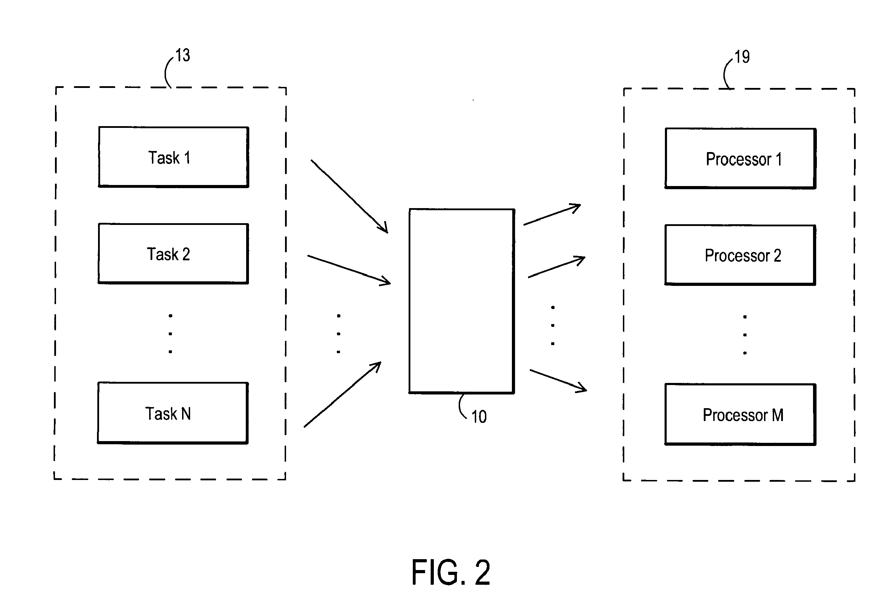

Generally speaking, the inventive concepts contemplate various ways of running software in a parallel fashion or executing algorithms in parallel. FIGs. 1 and 2 show two examples of techniques that may be used. Persons of ordinary skill in the art who have the benefit of the description of the invention understand that other techniques and examples may be used, as desired.

FIG. 1 shows a technique for parallelization used in exemplary embodiments by using multiple threads. The arrangement shown in FIG. 1 includes a set of tasks 13, a scheduler 10, and a set of threads 16. The set of tasks 13 make up the various tasks that the CAD software or algorithm seeks to execute or run. Generally, set 13 may include any desired number of tasks, say, *N* tasks, whereas the set of threads 16 may include any desired or suitable number of threads, say, *K* threads (note that *K* and *N* may or may not be equal).

Scheduler 10 accepts tasks from set 13 and schedules them for execution on one or more computers. More specifically, scheduler 10 assigns the tasks in set 13 to the threads in set 16. For example, scheduler 10 may assign task 1 to thread 1, task 2 to thread 2, and so on. The assignment to the threads will then result in execution of the corresponding assigned tasks.

FIG. 2 illustrates another technique for parallelization used in exemplary embodiments by using multiple processors. The arrangement in FIG. 2 includes a set of tasks 13, a scheduler 10, and a set of processors or computers or similar appropriate apparatus, labeled as 19. As an example, the set of processors 19 may constitute a parallel computer, a massively parallel computer, etc., as persons of ordinary skill in the art who have the benefit of the description of the invention understand.

The set of tasks 13 represents the various tasks that the CAD software or algorithm seeks to execute or run. Generally, set 13 may include any desired number of tasks, say, *N* tasks, whereas the set of processors 19 may include any desired or suitable number of processors, say, *M* threads (note that *K* and *M* may or may not be equal).

Scheduler 10 accepts tasks from set 13 and schedules them for execution by one or more computers. More specifically, scheduler 10 assigns tasks in set 13 to the processors in set 19. For example, scheduler 10 may assign task 1 to processor 1, task 2 to processor 2, and so on. The assignment of the tasks to the processors will then result in execution of the corresponding assigned tasks.

One may apply the inventive concepts to a variety of CAD software, algorithms, and applications, as desired. One particular area of application constitutes CAD software for designing and using PLDs (e.g., implementing a user's design by using the PLD's resources). The following description provides details of such PLDs and the software parallelization techniques.

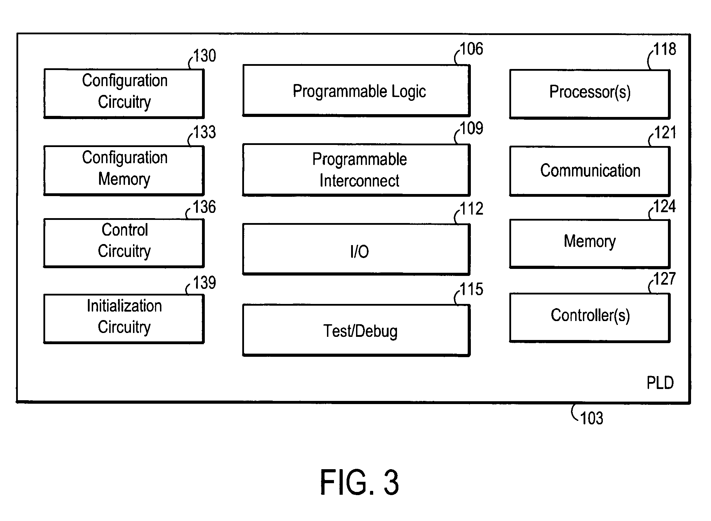

FIG. 3 depicts a general block diagram of a PLD that may be designed or used via illustrative embodiments of the invention. One may use the disclosed concepts for parallelizing software in CAD software for designing PLD 103 or using its resources to implement a desired circuit or system.

PLD 103 includes configuration circuitry 130, configuration memory (CRAM) 133, control circuitry 136, programmable logic 106, programmable interconnect 109, and I/O circuitry 112. In addition, PLD 103 may include test/debug circuitry 115, one or more processors 118, one or more communication circuitry 121, one or more memories 124, one or more controllers 127, and initialization circuit 139, as desired.

Note that the figure shows a simplified block diagram of PLD 103. Thus, PLD 103 may include other blocks and circuitry, as persons of ordinary skill in the art understand. Examples of such circuitry include clock generation and distribution circuits, redundancy circuits, and the like. Furthermore, PLD 103 may include, analog circuitry, other digital circuitry, and/or mixed-mode circuitry, as desired.

Programmable logic 106 includes blocks of configurable or programmable logic circuitry, such as look-up tables (LUTs), product-term logic, multiplexers (MUXs), logic gates, registers, memory, and the like. Programmable interconnect 109 couples to programmable logic 106 and provides configurable interconnects (coupling mechanisms) between various blocks within programmable logic 106 and other circuitry within or outside PLD 103.

Control circuitry 136 controls various operations within PLD 103. Under the supervision of control circuitry 136, PLD configuration circuitry 130 uses configuration data (which it obtains from an external source, such as a storage device, a host, etc.) to program or configure the functionality of PLD 103. Configuration data are typically used to store information in CRAM 133. The contents of CRAM 133 determine the functionality of various blocks of PLD 103, such as programmable logic 106 and programmable interconnect 109. Initialization circuit 139 may cause the performance of various functions at reset or power-up of PLD 103.

I/O circuitry 112 may constitute a wide variety of I/O devices or circuits, as persons of ordinary skill in the art who have the benefit of the description of the invention understand. I/O circuitry 112 may couple to various parts of PLD 103, for example, programmable logic 106 and programmable interconnect 109. I/O circuitry 112 provides a mechanism and circuitry for various blocks within PLD 103 to communicate with external circuitry or devices.

Test/debug circuitry 115 facilitates the testing and troubleshooting of various blocks and circuits within PLD 103. Test/debug circuitry 115 may include a variety of blocks or circuits known to persons of ordinary skill in the art who have the benefit of the description of the invention. For example, test/debug circuitry 115 may include circuits for performing tests after PLD 103 powers up or resets, as desired. Test/debug circuitry 115 may also include coding and parity circuits, as desired.

PLD 103 may include one or more processors 118. Processor 118 may couple to other blocks and circuits within PLD 103. Processor 118 may receive data and information from circuits within or external to PLD 103 and process the information in a wide variety of ways, as persons skilled in the art with the benefit of the description of the invention appreciate. One or more of processor(s) 118 may constitute a digital signal processor (DSP). DSPs allow performing a wide variety of signal processing tasks, such as compression, decompression, audio processing, video processing, filtering, and the like, as desired.

PLD 103 may also include one or more communication circuits 121. Communication circuit(s) 121 may facilitate data and information exchange between various circuits within PLD 103 and circuits external to PLD 103, as persons of ordinary skill in the art who have the benefit of the description of the invention understand.

PLD 103 may further include one or more memories 124 and one or more controller(s) 127. Memory 124 allows the storage of various data and information (such as user-data, intermediate results, calculation results, etc.) within PLD 103. Memory 124 may have a granular or block form, as desired. Controller 127 allows interfacing to, and controlling the operation and various functions of circuitry outside the PLD. For example, controller 127 may constitute a memory controller that interfaces to and controls an external synchronous dynamic random access memory (SDRAM), as desired.

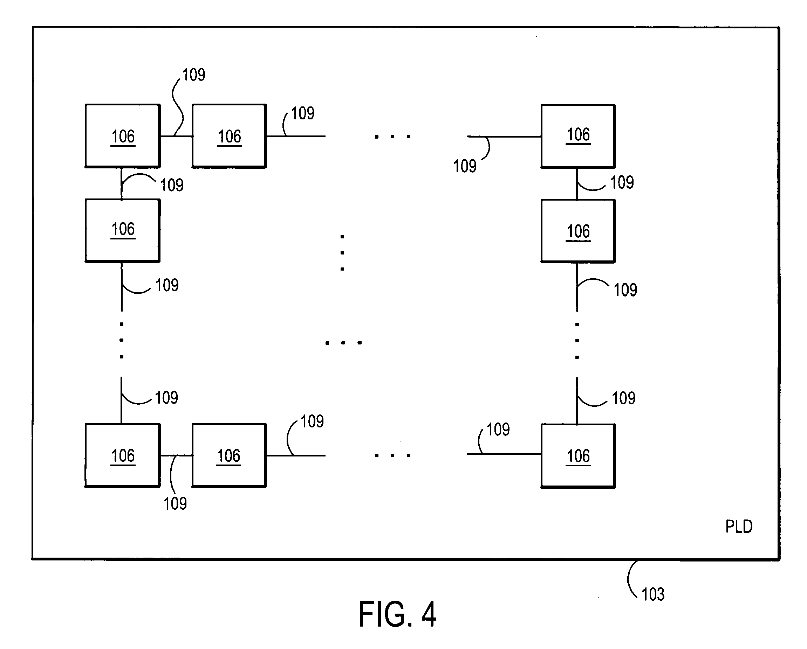

As noted, PLD 103 includes a number of blocks of programmable resources. Implementing a design using those resources often entails placement of those blocks (described below) within PLD 103's floorplan. FIG. 4 shows a floor-plan of a PLD that one may design or implement by using the inventive concepts.

PLD 103 includes programmable logic 106 arranged as a two-dimensional array. Programmable interconnect 109, arranged as horizontal interconnect and vertical interconnect, couples the blocks of programmable logic 106 to one another. One may place the blocks in a particular manner so as to implement a user's design, as persons of ordinary skill in the art who have the benefit of the description of the invention understand.

In illustrative embodiments, PLD 103 has a hierarchical architecture. In other words, each block of programmable logic 106 may in turn include smaller or more granular programmable logic blocks or circuits. For example, in one embodiment, programmable logic 106 may constitute blocks of configurable logic named logic array block (LAB), and each LAB may include logic elements (LEs) or other circuitry, as desired.

Persons of ordinary skill in the art who have the benefit of the description of the invention understand, however, that a wide variety of other arrangements, with varying terminology and topology, are possible, and fall within the scope of the inventive concepts. Furthermore, although FIG. 4 shows blocks of programmable logic 106, one may use PLDs with other or additional blocks (e.g., memory, processors, other blocks in FIG. 3, etc.) in their floorplans and take advantage of the inventive concepts, as persons of ordinary skill in the art who have the benefit of the description of the invention understand.

Regardless of the particular arrangement or design, however, one may use the inventive concepts in CAD software or programs to exploit the PLD's resources and implement a desired circuit or system. Implementing a user's design in a PLD, such as PLD 103, entails a number of steps or processes, as detailed below.

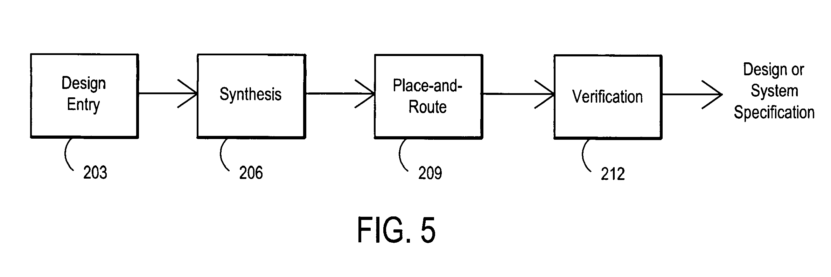

FIG. 5 illustrates various software modules that PLD CAD software according to illustrative embodiments of the invention uses. The modules include design-entry module 203, synthesis module 206, place-and-route module 209, and verification module 212. The following description provides a simplified explanation of the operation of each module.

The CAD techniques may have a variety of applications, as persons of ordinary skill in the art who have the benefit of the description of the invention understand. Examples include design area, timing performance, power requirements, and routability, as desired.

Design-entry module 203 allows the editing of various design description files using graphical or textual descriptions of a circuit or its behavior, such as schematics, hardware description languages (HDL), or waveforms, as desired.. The user may generate the design files by using design-entry module 203 or by using a variety of electronic design automation (EDA) or CAD tools (such as industry-standard EDA tools), as desired. The user may enter the design in a graphic format, a waveform-based format, a schematic format, in a text or binary format, or as a combination of those formats, as desired.

Synthesis module 206 accepts the output of design-entry module 203. Based on the user-provided design, synthesis module 206 generates appropriate logic circuitry that realizes the user-provided design. One or more PLDs (not shown explicitly) implement the synthesized overall design or system. Synthesis module 206 may also generate any glue logic that allows integration and proper operation and interfacing of various modules in the user's designs. For example, synthesis module 206 provides appropriate hardware so that an output of one block properly interfaces with an input of another block. Synthesis module 206 may provide appropriate hardware so as to meet the specifications of each of the modules in the overall design or system.

Furthermore, synthesis module 206 may include algorithms and routines for optimizing the synthesized design. Through optimization, synthesis module 206 seeks to more efficiently use the resources of the one or more PLDs that implement the overall design or system. Synthesis module 206 provides its output to place-and-route module 209.

Place-and-route module 209 uses the designer's timing specifications to perform optimal logic mapping and placement. The logic mapping and placement determine the use of routing resources within the PLD(s). In other words, by use of particular programmable interconnects with the PLD(s) for certain parts of the design, place-and-route module 209 helps optimize the performance of the overall design or system. By proper use of PLD routing resources, place-and-route module 209 helps to meet the critical timing paths of the overall design or system.

Place-and-route module 209 optimizes the critical timing paths to help provide timing closure faster in a manner known to persons of ordinary skill in the art with the benefit of the description of the invention. As a result, the overall design or system can achieve faster performance (*i.e*., operate at a higher clock rate or have higher throughput).

Verification module 212 performs simulation and verification of the design. The simulation and verification seek in part to verify that the design complies with the user's prescribed specifications. The simulation and verification also aim at detecting and correcting any design problems before prototyping the design. Thus, verification module 212 helps the user to reduce the overall cost and time-to-market of the overall design or system.

Verification module 212 may support and perform a variety of verification and simulation options, as desired. The options may include functional verification, test-bench generation, static timing analysis, timing simulation, hardware/software simulation, in-system verification, board-level timing analysis, signal integrity analysis and electromagnetic compatibility (EMC), formal netlist verification, and the like, as persons of ordinary skill in the art who have the benefit of the description of the invention understand.

Note that one may perform other or additional verification techniques as desired and as persons of ordinary skill in the art who have the benefit of the description of the invention understand. Verification of the design may also be performed at other phases in the flow, as appropriate, and as desired.

A large number (probably the majority) of conventional commercial CAD algorithms are serial in nature. In other words, they carry out the various tasks in a serial, rather than parallel, fashion. This is not surprising, first because processor clock speeds have been speeding up regularly until now, and second because it is generally much more difficult to develop robust parallel software.

With the trends described above, it is now much more important to modify existing algorithms to leverage the new parallel processing power that will be available to users. This is particularly true because CAD algorithms are generally among the slowest types of software in use. Typical run-times of a full weekend are quite common. Unless parallelization techniques are used, the serial algorithms will likely not speed up sufficiently to meet the more complex problems they will be used to solve in the future.

Generally, two approaches are commonly used when parallelizing a serial CAD algorithm. In the first approach, one discards the serial algorithm and uses instead an algorithm that has more inherent parallelism. This option has several disadvantages.

First, it forces the designer to start from scratch, discarding existing code and developing new parallel code. Given that many person-years of effort have been invested into optimizing existing algorithms, discarding them makes it difficult to reach the same level of quality in the new algorithms until many years later. The approach also restricts the choice of algorithms available to the designer - some serial algorithms are better suited to certain problems, and being forced to use a parallel algorithm can hurt the quality of the software tool.

In addition, parallel algorithms are relatively difficult to make deterministic. Deterministic algorithms give the same result when run multiple times with the same input. Parallel programs or algorithms, however, are executing multiple sets of instructions simultaneously and, depending on the access given by each processor to these sets, the results can be different each time the algorithm is run. This property makes it hard for a user to reproduce a result they get with the algorithm, as well as for the vendor to debug any issues the user encounters.

Finally, for users who are still using a single processor to run the algorithm, forcing a change to a parallel algorithm with the potential loss of quality described above, and the other shortcoming mentioned above would make the users dissatisfied. In addition, parallel algorithms generally incur overhead that could result the program becoming significantly slower for these users. The software tool vendor would therefore need to maintain both sets of algorithms for at least a short period of time, leading to higher maintenance costs.

As the second option, one might run the serial algorithm on each available processor with different settings, and take the best result at the end. This conventional approach, although easier to implement than the first one, has several limitations as well.

First, it doesn't involve speeding up the algorithm - it merely runs more copies of the algorithm to improve the results. Any user who wants the fastest possible run-time for the algorithm is not going to get what they want with this approach. Second, it doesn't scale well as more processors are made available because the ability to get better results from multiple runs of the same algorithm quickly diminishes as more and more copies are run. Clearly, both of these approaches have important limitations. The inventive concepts, however, provide techniques that overcome those limitations.

More specifically, the inventive method takes advantage of the fact that many serial CAD algorithms spend most of their execution time performing a particular action or set of actions on different portions of the input problem. This action is repeated many times (often millions of times), which results in relatively long run-times for these algorithms. The property that makes these algorithms serial is often the fact that each action is performed with knowledge of the results of each previous action (i.e., dependence on previous actions). This property in turn means that one action can be or is done at any time, which limits the algorithm to serial execution.

Often, however, a given set of contiguous actions are affecting independent portions of the input problem, thereby removing the need for them all to be performed serially. This property holds especially for input problems that are relatively large. For example, in a problem that includes many actions, including actions #10 to #20, action #10 to action #20 may be independent of one another. In other words, performing the actions does not depend on the result(s) of performing other action(s).

In such a situation, the algorithm could perform all of those 11 actions in parallel. In exemplary embodiments, the inventive techniques use local independence to create parallel execution. For example, if action #21 is then dependent on two of the previous actions (say #13 and #17), the algorithm must finish action #13 and #17 before it can proceed with #21 (otherwise the results will not be deterministic). Otherwise, the algorithm can perform the actions in parallel. This local independence is what this method uses to create parallelism and, hence, improved performance.

The inventive technique uses a queue of actions, where the queue is loaded with actions that are independent of each other. This queue is loaded serially to ensure that the actions are all independent. In one variant of the invention, the queue is loaded in the same order as the serial algorithm would perform actions. This action ensures that the results of the parallel version of the algorithm are similar or identical to those of the serial version.

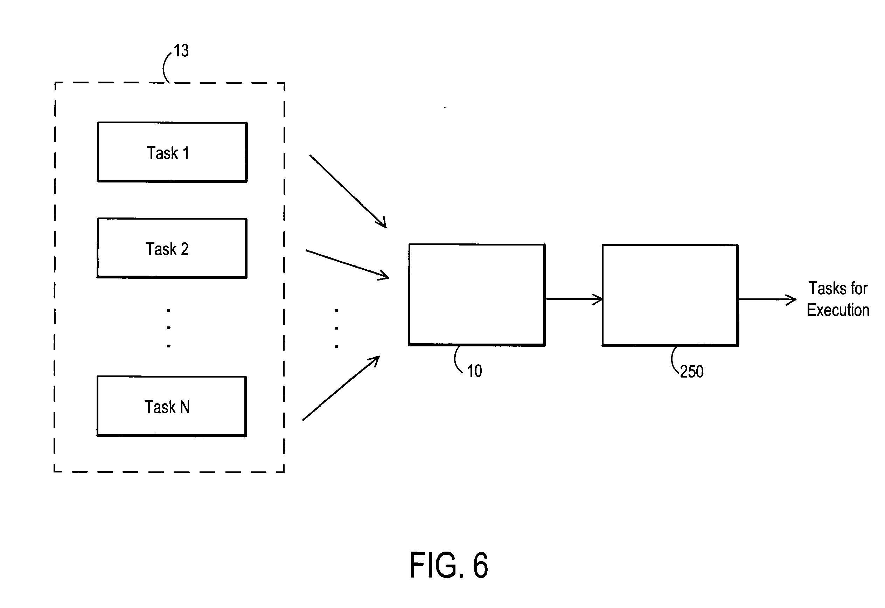

FIG. 6 shows a simplified block diagram of this technique. A set of tasks 13 are input to scheduler 10. Scheduler 10 provides tasks to queue 250 so as to provide local independence, as described above. The tasks are output from queue 250 and executed in parallel manner (as long as local independence exists).

In another variant of the invention, actions can be chosen in ways that maximize the number of independent actions that the queue holds. Once this queue is loaded, all available processors can process the actions in any arbitrary or desired order they choose because the independence of the actions in the queue is guaranteed. Once all the actions in the queue are finished, the queue is loaded again and the process repeated.

To illustrate the technique in more detail, a placement example is provided to show how it can be used to parallelize a placement algorithm. A placement algorithm takes as input a netlist representation of a circuit, and a floorplan representation of a device. In the Quartus II software (available from Altera Corporation, the assignee of this application), for example, the netlist represents the blocks in a user's logic circuit (e.g., logic array blocks, or LABs; RAM blocks; multiplier blocks, etc). The floorplan represents the blocks available in a PLD or similar device.

A serial placement algorithm may operate as follows: Create an initial legal placement as quickly as possible, or relatively quickly, with little or no regard to quality. As a result, every block in the netlist has been assigned a location in the floorplan. Second, randomly pick a block in the netlist and try to move it to a random location. Swap any block that is already there with the source block. Third, evaluate whether this change to the placement is good or desirable. If so, commit the change. Otherwise, discard the change. The evaluation is often done with several metrics and, generally, the metrics generally try to keep blocks that are connected or coupled to each other placed near each other. Finally, go back to the second step and repeat until a given number of moves are done (for example, this number might be 1000 times the number of blocks in the netlist).

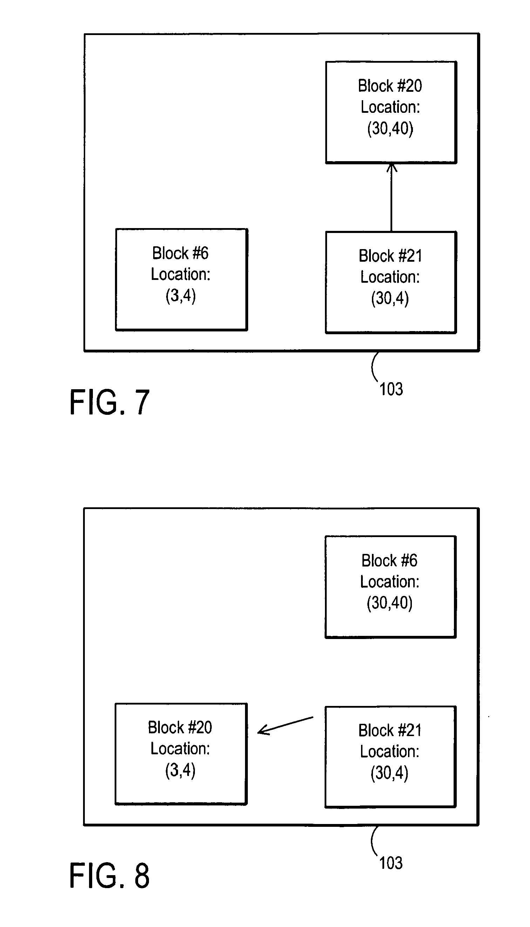

The placement algorithm above is serial in nature because the decision to commit a change in the third step affects all future iterations (i.e., moves) of the algorithm. For example, assume the floorplan shown in FIG. 7. Assume block #6 is at X=3 and Y=4 in the floorplan, and the first move of the algorithm attempts to swap it with block #20, which is at X=30 and Y=40.

Further, assume that the second move of the algorithm is going to move block #21 (which happens to be connected or coupled to block #20) from X=30, Y=4 to X=1, Y=1. FIG. 8 shows what the locations and connectivity would be if the first move was accepted.

If the first move of the algorithm accepts the move, the second move (which is attempting to move block #21 to (1,1)) is more likely to be accepted since block #21's new location (1,1) will be closer to the block it is connected or coupled to (i.e., block #20, which has a current location of (3,4)). If the first move was not accepted (leaving the situation in FIG. 7), however, moving block #21 to (1,1) will not seem like a good move because its connected or coupled block (i.e., block #20) is at (30,40), and the current location for block #21 (i.e., 30,4) is closer than (1,1) would be.

This example shows the problem that an algorithm like the above serial algorithm would face if it were running in parallel. For example, if move #1 and #2 are running at the same time, whether move #2 is accepted or not depends on whether move #1 finishes before move #2 is evaluated.

Unless changes are made to the algorithm, running it in parallel could result in blocks chasing the last location that its connected or coupled blocks resided at, potentially reducing the quality of the final placement drastically. It would also make the results non-deterministic, as it is generally impossible to predict how long a given move will take to complete even for different runs of the same circuit.

To apply the inventive technique to solve these issues, one could make a queue of independent moves, as noted above. When the first move from the example above is placed into the queue, the second move would no longer be allowed into the queue (because that move depends on the first one through the connection or coupling between block #21 and block #20). The queue loading could be stopped and the moves processed, or the queue could be loaded with other independent moves before processing the moves, as described above. In either case, the larger the queue is, the greater the speedup will be from having multiple processors. For example, a queue that always has no more than two moves in it would see a benefit from using two processors (but not four or more).

Note that the above technique uses serial loading of the queue. If the time it takes to propose a move is relatively small, the serial loading does not pose a problem. For instance, an algorithm where the loading takes 5% of serial runtime and the evaluation takes 95% runtime could theoretically be sped up by a factor of 1.9 on a two-processor machine. If the serial portion is higher, however, this benefit may drop off dramatically. For example, if merely half the algorithm is parallel, then the speedup on a two-processor system would be limited to a factor of 1.33.

By using a relatively more sophisticated queue, however, it is possible to alleviate this problem. Returning to the placement example above, we note that there are two sources of dependence between moves: (1) it may be impossible to propose an independent move; and (2) it may be impossible to evaluate a move independently.

These two instances are treated similarly or identically, but they are quite different. For example, consider two proposed moves for a single block. Obviously, one cannot even propose the second move until the first one has been either committed or rejected, as one does not know where the block will be after the first move.

On the other hand, consider two blocks that one wishes to move closer together. One could easily propose a move for both blocks at the same time. One would not be able to evaluate them independently (because, depending on which block is moved first, the second move might not be good or desirable or advantageous). Note, though, that one would be able to proceed and propose other moves even before the moves for the blocks have both been evaluated. From a parallel viewpoint, doing so could be advantageous, as it enables one to keep generating work for all the processors in far more circumstances than one could when any kind of dependency causes a stall.

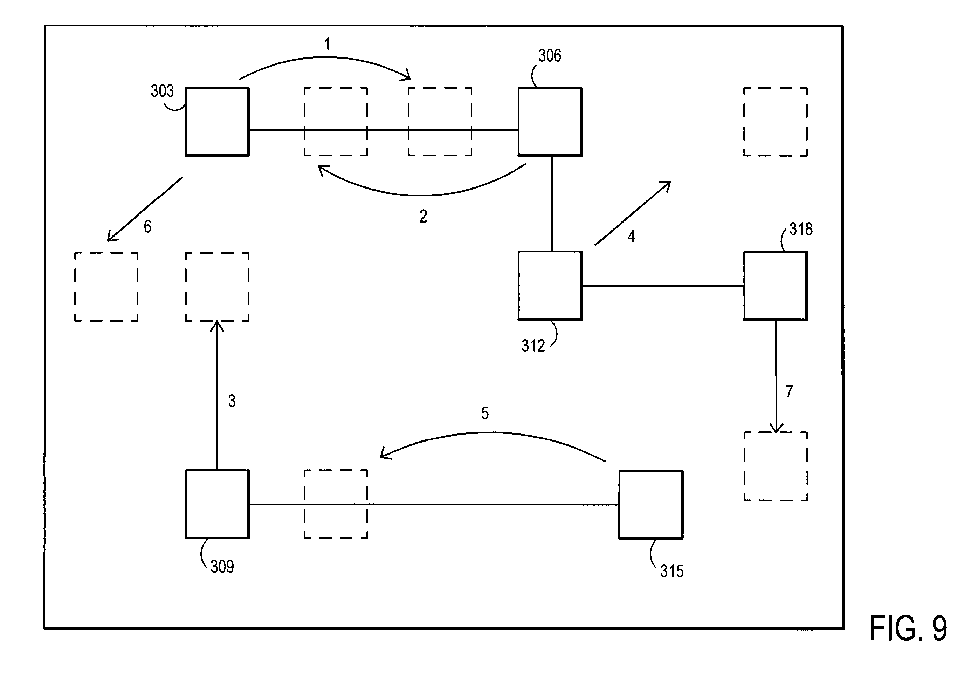

The following describes an example of the application of this improvement. Consider the placement in FIG. 9, with several moves being proposed regarding blocks 303-315. Using the original inventive algorithm described above, one would propose the first move, then stop after proposing the second move because they are related to connected or coupled blocks, and hence the decision to accept or reject move #2 will depend on the result of move #1 (in other words, move #1 would move block 303, and move #2 would move block 306, which is coupled to block 303).

One, however, could then evaluate moves #2 and #3 (moving block 309) in parallel, then move #4 (moving block 312), #5 (moving block 315) and #6 (moving block 303), and finally move #7 (moving block 318). Note that the placement has stopped three times, and that in the four "sets" of moves, half the sets had a single block moving. Thus, for half the time, one processor on a dual-core machine (as an example) would be sitting idle.

If instead one stops when moves could no longer be proposed, however, the situation improves. For instance, one may propose moves #1 through #5 without stopping. Note that one would stop at move #6 because it targets a block (i.e., block 303) that may already be moving as a result of another move. One may resume as soon as move #1 has been accepted or rejected, and proceed to propose move #7. In other words, one may resume when one or more dependencies on one or more earlier move(s) have been resolved.

Now, at any given time, there are always at least two moves that can be evaluated in parallel (move #3 in parallel with #1; move #4 with #3; move #5 with moves #4 and move #2; move #6 with move #3; moves #4, #5, and #7 with moves #3, #5, and #6). Persons of ordinary skill in the art who have the benefit of the description of the invention appreciate how, using this technique, one would also have a much greater chance of ensuring that one could generate 4 or 8 or even more moves at a time, thus being able to take advantage of machines with more than two processors, as desired.

To implement this algorithm, the inventive concepts use a more sophisticated or "smart" or improved or enhanced queue. More specifically, instead of keeping all its moves in order and allowing processors to work on the next one that's available, such a queue keeps track of the last move which should be accepted or rejected before each move can be evaluated. For instance, move #2 would list move #1, and move #6 would list #2 (but not moves #3, #4, or #5). A processor that finishes evaluating move #2, for example, would be able to start work on move #6 even if moves #3, #4, and #5 have not yet been completed.

One may use this technique in a variety of situations. For example, one may substitute such a queue for queue 250 in FIG. 6, as desired. Alternatively, one may use other arrangements, as desired, and as persons of ordinary skill in the art who have the benefit of the description of the invention understand.

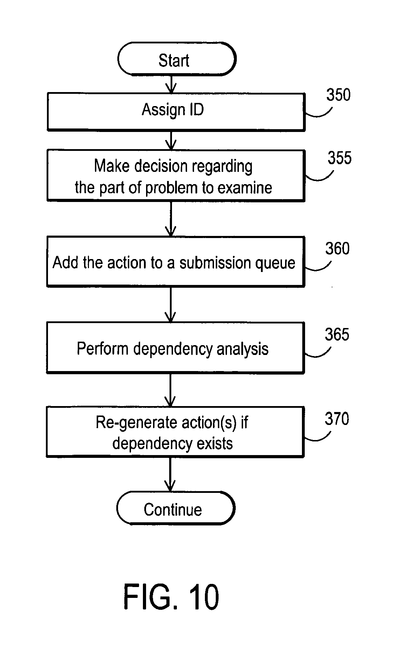

If even the speedup allowed by the enhanced or improved queues is not enough, it is also possible to have different threads choose which portions of the input problem they wish to work on in parallel. Note that doing so will still maintain deterministic results. Using the placement example above, this approach would mean that not only do we evaluate the moves in parallel, we also generate them in parallel. The technique operates as described below and as shown in FIG. 10.

As described above, at 350 every action is given a numerical ID. Multiple threads, however, may at 355 make a decision as to which part of the input problem they choose to examine (e.g., which blocks each thread proposes to move). The respective thread, however, does not actually perform the action.

The thread then adds the action to a submission queue at 360. This queue accepts actions in any order, but will emit them in order of their ID numbers. For instance, if action #1 and #3 are added, the queue will appear to have one action in it (#1) until action #2 is also added.

As actions are removed from the queue, at 365 one performs the dependency analysis, as described above. If an action is found to be dependent on a previous action, one processes it as described above. The action itself, however, may be invalid. For example, one may be proposing a move for a block that may no longer be in the location that was anticipated. Note that if this situation had arisen with the versions of the technique described herein, one would simply have stopped generating new actions. Given that with the improved technique one may have multiple threads generating actions in parallel, that would be a relatively more serious limitation.

Once this relatively more serious kind of dependency is found, a thread is simply asked at 370 to re-generate the action, preferably as soon as possible. For example, "as soon as possible" might be when it is determined whether or not the targeted block has actually moved. If it hasn't, one may simply evaluate the move; if it has, however, one proposes or considers a new move from scratch and evaluate that move instead.

The benefit of this technique is that, because no parts of the algorithm are serial (except the dependency checker, which one assumes is relatively fast), one expects to be able to accelerate the entire program as much as is theoretically possible, given its inherent dependencies. Note that the algorithm introduces almost no new dependencies of its own.

There are other approaches beyond PLD CAD applications that are specific to particular algorithms that can be used to take advantage of parallel processing power without significantly affecting algorithm design flexibility. One example is parallel analysis.

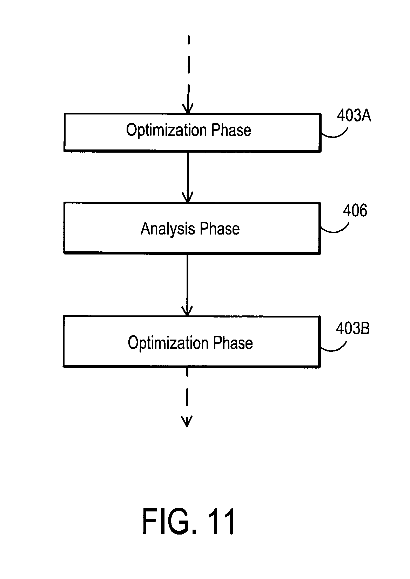

More specifically, optimization algorithms often rely on analysis engines to determine how much effort should be applied (and where that effort should be applied) to achieve various design goals. These analysis engines often take a snapshot of the current state and return the results of the analysis for that state. A serial algorithm, shown in FIG. 11, will wait for that analysis and proceed when it is done (e.g., optimization phase 403B awaits results of analysis phase 406, which in turn receives its input from optimization phase 403A). Consequently, it has the disadvantages described above.

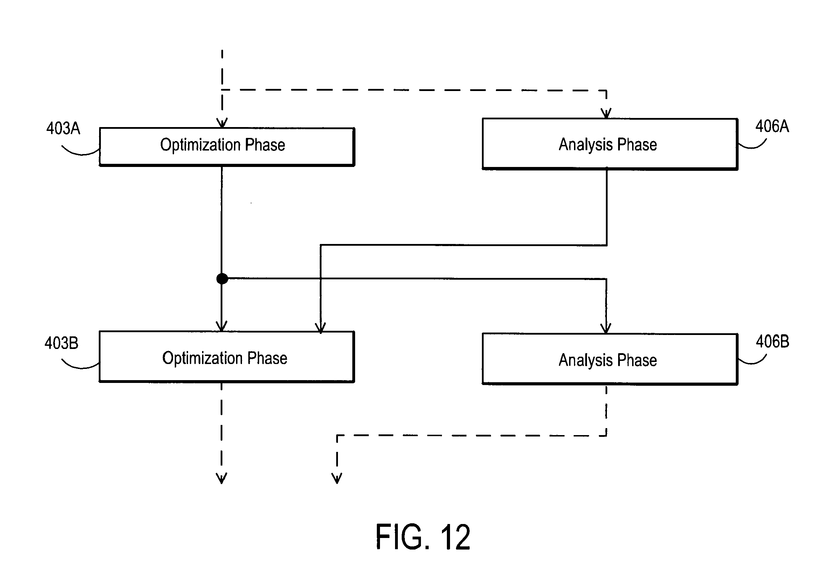

To make the algorithms parallel, one can have additional processors constantly taking snapshots of the state and performing the analysis. This has one disadvantage in that the analysis results will be stale since the state used for the analysis will not be current when the analysis results are made available but, on the other hand, the parallelism provides for increased efficiency and reduced resource demands. FIG. 12 shows how this process works.

In the technique shown in FIG. 12, one may perform analysis and optimization in parallel. For example, optimization phase or engine 403A may operate in parallel or currently with analysis phase or engine 406A. Similarly, optimization phase or engine 403B may operate in parallel or currently with analysis phase or engine 406B. In this scenario, the analysis phase is performed on a previous optimization state. The results of the analysis phase are fed back to the optimization phase after the state of the optimization has potentially changed.

Note that the input to each analysis step is from a different optimization state than the state that uses its output. For example, assume the optimization step is placement (where, say, thousands of moves are being made to blocks), and the analysis step is timing analysis, which provides input to the placement phase regarding which connections are most timing-critical. This technique provides the advantage that analysis and optimization are performed concurrently or in parallel, albeit potentially (but not necessarily) at the cost of a less optimal solution.

Examples of analysis that this technique may be applied to include timing analysis (determining the timing performance of each path in a circuit); congestion analysis (determining which areas of a chip are likely to face routing congestion based on the placement of the design); and design analysis (determining for what portions of the design more focus for optimization is desirable or beneficial (or required)). Note that the examples listed are illustrative, and that one may apply the techniques to other applications or situations, as persons of ordinary skill in the art who have the benefit of the description of the invention understand.

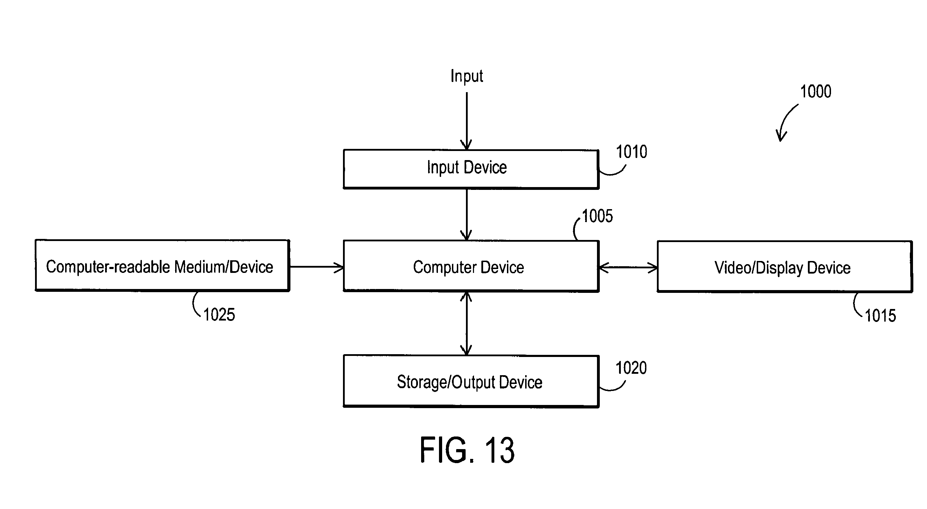

As noted above, one may run or execute algorithms or software according to the invention on computer systems or processors. FIG. 13 shows a block diagram of an exemplary system for processing information according to the invention.

System 1000 includes a computer device 1005, an input device 1010, a video/display device 1015, and a storage/output device 1020, although one may include more than one of each of those devices, as desired.

The computer device 1005 couples to the input device 1010, the video/display device 1015, and the storage/output device 1020. The system 1000 may include more that one computer device 1005, for example, a set of associated computer devices or systems, as desired.

The system 1000 operates in association with input from a user. The user input typically causes the system 1000 to perform specific desired information-processing tasks, including circuit simulation. The system 1000 in part uses the computer device 1005 to perform those tasks. The computer device 1005 includes an information-processing circuitry, such as a central-processing unit (CPU), although one may use more than one CPU or information-processing circuitry, as persons skilled in the art would understand.

The input device 1010 receives input from the user and makes that input available to the computer device 1005 for processing. The user input may include data, instructions, or both, as desired. The input device 1010 may constitute an alphanumeric input device (*e.g*., a keyboard), a pointing device (*e.g.*, a mouse, roller-ball, light pen, touch-sensitive apparatus, for example, a touch-sensitive display, or tablet), or both. The user operates the alphanumeric keyboard to provide text, such as ASCII characters, to the computer device 1005. Similarly, the user operates the pointing device to provide cursor position or control information to the computer device 1005.

The video/display device 1015 displays visual images to the user. The visual images may include information about the operation of the computer device 1005, such as graphs, pictures, images, and text. The video/display device may constitute a computer monitor or display, a projection device, and the like, as persons of ordinary skill in the art would understand. If a system uses a touch-sensitive display, the display may also operate to provide user input to the computer device 1005.

The storage/output device 1020 allows the computer device 1005 to store information for additional processing or later retrieval (*e.g.*, softcopy), to present information in various forms (*e.g.*, hardcopy), or both. As an example, the storage/output device 1020 may constitute a magnetic, optical, or magneto-optical drive capable of storing information on a desired medium and in a desired format. As another example, the storage/output device 1020 may constitute a printer, plotter, or other output device to generate printed or plotted expressions of the information from the computer device 1005.

The computer-readable medium 1025 interrelates structurally and functionally to the computer device 1005. The computer-readable medium 1025 stores, encodes, records, and/or embodies functional descriptive material. By way of illustration, the functional descriptive material may include computer programs, computer code, computer applications, and/or information structures (*e.g.*, data structures or file systems). When stored, encoded, recorded, and/or embodied by the computer-readable medium 1025, the functional descriptive material imparts functionality. The functional descriptive material interrelates to the computer-readable medium 1025.

Information structures within the functional descriptive material define structural and functional interrelations between the information structures and the computer-readable medium 1025 and/or other aspects of the system 1000. These interrelations permit the realization of the information structures' functionality. Moreover, within such functional descriptive material, computer programs define structural and functional interrelations between the computer programs and the computer-readable medium 1025 and other aspects of the system 1000. These interrelations permit the realization of the computer programs' functionality.

By way of illustration, the computer device 1005 reads, accesses, or copies functional descriptive material into a computer memory (not shown explicitly in the figure) of the computer device 1005. The computer device 1005 performs operations in response to the material present in the computer memory. The computer device 1005 may perform the operations of processing a computer application that causes the computer device 1005 to perform additional operations. Accordingly, the functional descriptive material exhibits a functional interrelation with the way the computer device 1005 executes processes and performs operations.

Furthermore, the computer-readable medium 1025 constitutes an apparatus from which the computer device 1005 may access computer information, programs, code, and/or applications. The computer device 1005 may process the information, programs, code, and/or applications that cause the computer device 1005 to perform additional operations.

Note that one may implement the computer-readable medium 1025 in a variety of ways, as persons of ordinary skill in the art would understand. For example, memory within the computer device 1005 may constitute a computer-readable medium 1025, as desired. Alternatively, the computer-readable medium 1025 may include a set of associated, interrelated, coupled (e.g., through conductors, fibers, etc.), or networked computer-readable media, for example, when the computer device 1005 receives the functional descriptive material from a network of computer devices or information-processing systems. Note that the computer device 1005 may receive the functional descriptive material from the computer-readable medium 1025, the network, or both, as desired.

Note that one may apply the inventive concepts effectively to various ICs that include ICs with programmable or configurable circuitry, known by other names in the art, as desired, and as persons skilled in the art with the benefit of the description of the invention understand. Such circuitry include, for example, devices known as complex programmable logic device (CPLD), programmable gate array (PGA), field programmable gate array (FPGA), and structured application specific ICs, or structured ASICs.

Referring to the figures, persons of ordinary skill in the art will note that the various blocks shown may depict mainly the conceptual functions and signal flow. The actual circuit implementation may or may not contain separately identifiable hardware for the various functional blocks and may or may not use the particular circuitry shown. For example, one may combine the functionality of various blocks into one circuit block, as desired. Furthermore, one may realize the functionality of a single block in several circuit blocks, as desired. The choice of circuit implementation depends on various factors, such as particular design and performance specifications for a given implementation, as persons of ordinary skill in the art who have the benefit of the description of the invention understand. Other modifications and alternative embodiments of the invention in addition to those described here will be apparent to persons of ordinary skill in the art who have the benefit of the description of the invention. Accordingly, this description teaches those skilled in the art the manner of carrying out the invention and are to be construed as illustrative only.

The forms of the invention shown and described should be taken as the presently preferred or illustrative embodiments. Persons skilled in the art may make various changes in the shape, size and arrangement of parts without departing from the scope of the invention described in this document. For example, persons skilled in the art may substitute equivalent elements for the elements illustrated and described here. Moreover, persons skilled in the art who have the benefit of this description of the invention may use certain features of the invention independently of the use of other features, without departing from the scope of the invention.

## Claims

1. A system for providing parallelization in computer aided design (CAD) software, the system comprising:
a computer, configured to:
identify a set of tasks having independence;
assign each task in the set of tasks to be performed in parallel; and
perform each task in the set of tasks.

2. The system according to claim 1, wherein the computer is configured to load a queue with the set of tasks.

3. The system according to claim 2, wherein the queue is loaded in an order similar to a serial CAD algorithm so that the parallelized CAD software produces results similar to the serial algorithm.

4. The system according to claim 2, wherein the set of tasks are chosen so as to maximize a number of independent actions held in the queue.

5. The system according to claim 4, wherein the tasks are performed in an arbitrary order.

6. The system according to claim 2, wherein the queue is loaded with all tasks in the set of tasks before the set of tasks are performed.

7. The system according to claim 2, wherein the queue comprises an enhanced queue that allows additional tasks to be proposed while the set of tasks is being performed.

8. The system according to claim 2, wherein multiple threads determine a respective task to be performed, and add the task to the queue.

9. The system according to claim 8, wherein a thread re-generates a tasks in the event of dependence on another task.

10. The system according to claim 1, wherein the CAD software comprises placement algorithms for placement of resources in a programmable logic device (PLD).

11. The system according to claim 1, wherein the CAD software comprises a parallel analysis algorithm.

12. A computer program product, comprising:
a computer application adapted for processing by a computer to parallelize computer aided design (CAD) software, the computer application configured to cause the computer to:
identify a set of tasks having independence;
assign each task in the set of tasks to be performed in parallel; and
perform each task in the set of tasks.

13. The computer program product according to claim 12, causing the computer to load a queue with the set of tasks.

14. The computer program product according to claim 13, causing the computer to load the queue in an order similar to a serial CAD algorithm so that the parallelized CAD software produces results similar to the serial algorithm.

15. The computer program product according to claim 13, causing the compute to choose the set of tasks so as to maximize a number of independent actions held in the queue.

16. The computer program product according to claim 15, causing the computer to perform the tasks in an arbitrary order.

17. The computer program product according to claim 13, causing the computer to load the queue with all tasks in the set of tasks before the set of tasks are performed.

18. The computer program product according to claim 13, causing the computer to use an enhanced queue that allows additional tasks to be proposed while the set of tasks is being performed.

19. The computer program product according to claim 13, causing the computer to use multiple threads that determine a respective task to be performed, and add the task to the queue.

20. The computer program product according to claim 19, causing the computer to use a thread that re-generates a tasks in the event of dependence on another task.

21. The computer program product according to claim 12, causing the computer to perform placement of resources in a programmable logic device (PLD).

22. The computer program product according to claim 12, causing the computer to perform a parallel analysis algorithm.

23. A method of parallelizing computer aided design (CAD) software, the method comprising:
identifying a set of tasks having independence;
assigning each task in the set of tasks to be performed in parallel; and
performing each task in the set of tasks.

24. The method according to claim 23, further comprising loading a queue with the set of tasks.

25. The method according to claim 24, further comprising loading the queue in an order similar to a serial CAD algorithm so that the parallelized CAD software produces results similar to the serial algorithm.

26. The method according to claim 24, further comprising choosing the set of tasks so as to maximize a number of independent actions held in the queue.

27. The method according to claim 26, further comprising performing the tasks in an arbitrary order.

28. The method according to claim 24, further comprising loading the queue with all tasks in the set of tasks before the set of tasks are performed.

29. The method according to claim 24, wherein the queue comprises an enhanced queue that allows additional tasks to be proposed while the set of tasks is being performed.

30. The method according to claim 24, further comprising using multiple threads that determine a respective task to be performed and add the task to the queue.

31. The method according to claim 30, wherein a thread re-generates a tasks in the event of dependence on another task.

32. The method according to claim 23, wherein the CAD software comprises placement algorithms for placement of resources in a programmable logic device (PLD).

33. The method according to claim 23, wherein the CAD software comprises a parallel analysis algorithm.
